# EUROPEAN PATENT SPECIFICATION

(11) **EP 3 084 092 B1**
(45) Date of publication and mention of the grant of the patent: **28.07.2021**
(21) Application number: 14824296.9
(22) Date of filing: 16.12.2014
(51) Int. Cl.: E04B 1/80, B32B 33/00

(54) **BARRIER FILMS AND VACUUM INSULATED PANELS EMPLOYING SAME**
BARRIEREFOLIEN UND VAKUUMISOLIERTE PANEELE DAMIT
FILMS BARRIÈRES ET PANNEAUX ISOLÉS SOUS VIDE UTILISANT CEUX-CI

(30) Priority: 19.12.2013 US 201361918281 P; 15.10.2014 US 201462064120 P
(43) Date of publication of application: 26.10.2016
(73) Proprietor: 3M Innovative Properties Company, St. Paul, MN 55133-3427 (US)
(72) Inventor: LYONS, Christopher S., Saint Paul, Minnesota 55133-3427 (US); BANGE, Donna W., Saint Paul, Minnesota 55133-3427 (US); BEDOYA, Cedric, Saint Paul, Minnesota 55133-3427 (US); ENGEN, Paul T., Saint Paul, Minnesota 55133-3427 (US); HOGERTON, Peter B., Saint Paul, Minnesota 55133-3427 (US); PIEPER, Joseph M., Saint Paul, Minnesota 55133-3427 (US); PRESZLER PRINCE, Amy, Saint Paul, Minnesota 55133-3427 (US); YU, Ta-Hua, Saint Paul, Minnesota 55133-3427 (US); NIE, Qihong, Saint Paul, Minnesota 55133-3427 (US); MCCLURE, Donald J., Saint Paul, Minnesota 55133-3427 (US)
(74) Representative: Mathys & Squire
(86) International application number: PCT/US2014/070475
(87) International publication number: WO 2015/095114

(56) References cited:
- EP-A2- 0 722 787
- WO-A1-2010/014132
- US-A1- 2013 260 062
- M. ALAM ET AL: "Vacuum Insulation Panels (VIPs) for building construction industry - A review of the contemporary developments and future directions", APPLIED ENERGY, vol. 88, no. 11, 1 November 2011 (2011-11-01), pages 3592-3602, XP055165508, ISSN: 0306-2619, DOI: 10.1016/j.apenergy.2011.04.040

## Description

### FIELD

The present disclosure relates to durable barrier films. The present disclosure further provides vacuum insulated panels employing these barrier films.

### BACKGROUND

A vacuum insulated panel (VIP) is a form of thermal insulation consisting of a nearly gas-tight envelope surrounding a core, from which the air has been evacuated. It is used in, e.g. appliances and building construction to provide better insulation performance than conventional insulation materials. Since the leakage of air into the envelope would eventually degrade the insulation value of a VIP, known designs use foil laminated with heat-sealable material as the envelope to provide a gas barrier. However, the high thermal conductivity of the foil decreases the overall VIP thermal insulation performance due to the thermal bridging effect. On the other hand, metalized polymer substrates, like those used for food-grade packaging film, have low thermal conductivity, but do not meet the barrier requirements for VIP.

Figure 4 of an article by M. Alam et al entitled "Vacuum Insulation Panels (VIPs) for building construction industry" and published in Applied Energy 88 (2011) 3592-3602 shows a multilayer barrier envelope containing metalized barrier layers, said envelope including a HDPE/LDPE layer (adjacent to inner side of envelope) and three repeats of adhesive layer/aluminumlayer/PET layer (with a PET layer adjacent to outer side envelope).

US 2013/260062 describes an infrared-reflecting, composite film, comprising: a heat-shrunk, tensioned polymer sheet having a substantially transparent coating deposited on at least one surface, the transparent coating comprising a composite multilayer stack of dielectric and metallic layers, the stack comprising an amorphous indium oxide dielectric layer about 20 to about 80 nm thick in contact with the polymer sheet, a crystalline zinc - based oxide seed layer about 5 to about 15 nm thick deposited on the amorphous indium oxide dielectric layer, at least one low-emissivity silver or silver alloy layer deposited upon the zinc-based oxide seed layer, and an amorphous dielectric outer layer, wherein the zinc-based oxide seed layer has a thickness of about 5 to about 10 nm and comprises zinc oxide.

WO 2010/014132 describes a method of making an insulating glass (IG) window unit, the method comprising: sputtering a multi-layered low-E coating onto a glass substrate, wherein the low-E coating comprises at least one infrared (IR) reflecting layer comprising silver sandwiched between at least first and second dielectric layers; thermally tempering the glass substrate with the low-E coating thereon; after said tempering, applying a thermoplastic composition including a hot melt adhesive in liquid form to a top surface of the low-E coating and cooling the thermoplastic composition to form a protective sheet so as to create a protected coated article; peeling the protective sheet off of the low-E coating to form an unprotected coated article; and after peeling the protective sheet off of the low-E coating, coupling the tempered coated article including the glass substrate and low-E coating to another substrate to form an IG window unit, wherein an uppermost layer of the low-E coating comprises silicon nitride.

There exists a need for an envelope film which combines high barrier capabilities with a low thermal conductivity and a low emissivity features.

### SUMMARY

The present disclosure provides a barrier film with exceptional utility for use as the envelope for vacuum insulated panels. It combines puncture resistance, low-emissivity, and low-thermal conductivity.

Thus, in one aspect, the present disclosure provides a vacuum insulation panel envelope according to claim 1.

In some embodiments, an additional low conductivity organic layer may be present. An optional heat seal layer may also be present. A blend of linear low-density polyethylene and low-density polyethylene is considered suitable. A heat seal layer may be applied to the barrier film by extrusion, coating, or lamination. It may be convenient that the envelope have fire retardant properties. For example, the substrate may itself comprise a flame retardant material, or a separate flame retardant layer may be positioned in direct contact with an opposing major surface of the substrate opposite the first layer. It may be convenient for the vacuum insulation panel to further comprise a core layer. Vacuum insulation panel envelopes according to the present disclosure desirably have an oxygen transmission rate of less than 0.1 cc/m²/day and a moisture vapor transmission rate of less than 0.1 g/m²/day. Some of the embodiments of the present disclosure have an oxygen transmission rate of less than 0.005 cc/m²/day and a moisture vapor transmission rate of less than 0.005 g/m²/day.

In another aspect, the present disclosure provides a barrier film according to claim 9.

Various aspects and advantages of exemplary embodiments of the present disclosure have been summarized. The above Summary is not intended to describe each illustrated embodiment or every implementation of the present disclosure. Further features and advantages are disclosed in the embodiments that follow. The Drawings and the Detailed Description that follow more particularly exemplify certain embodiments using the principles disclosed herein.

### BRIEF DESCRIPTION OF THE DRAWINGS

The disclosure may be more completely understood in consideration of the following detailed description of various embodiments of the disclosure in connection with the accompanying figures, in which:
**FIG. 1** is a side view of an exemplary vacuum insulation panel envelope according to the present invention.
**FIG. 2** is a front view of an exemplary vacuum insulation panel employing the envelope of **FIG. 1****.**

While the above-identified drawings, which may not be drawn to scale, set forth various embodiments of the present disclosure, other embodiments are also contemplated, as noted in the Detailed Description. In all cases, this disclosure describes the presently disclosed invention by way of representation of exemplary embodiments and not by express limitations. It should be understood that numerous other modifications and embodiments can be devised by those skilled in the art, which fall within the scope of this disclosure.

### DETAILED DESCRIPTION

As used in this Specification, the recitation of numerical ranges by endpoints includes all numbers subsumed within that range (e.g. 1 to 5 includes 1, 1.5, 2, 2.75,3, 3.8, 4, and 5, and the like).

Unless otherwise indicated, all numbers expressing quantities or ingredients, measurement of properties and so forth used in the Specification and embodiments are to be understood as being modified in all instances by the term "about." Accordingly, unless indicated to the contrary, the numerical parameters set forth in the foregoing specification and attached listing of embodiments can vary depending upon the desired properties sought to be obtained by those skilled in the art utilizing the teachings of the present disclosure. At the very least, and not as an attempt to limit the application of the doctrine of equivalents to the scope of the claimed embodiments, each numerical parameter should at least be construed in light of the number of reported significant digits and by applying ordinary rounding techniques.

For the following defined terms, these definitions shall be applied for the entire Specification, including the claims, unless a different definition is provided in the claims or elsewhere in the Specification based upon a specific reference to a modification of a term used in the following Glossary:

### Glossary

The words "a", "an", and "the" are used interchangeably with "at least one" to mean one or more of the elements being described.

The term "layer" refers to any material or combination of materials on or overlaying a substrate.

The term "stack" refers to an arrangement where a particular layer is placed on at least one other layer but direct contact of the two layers is not necessary and there could be an intervening layer between the two layers.

Words of orientation such as "atop, "on," "covering," "uppermost," "overlaying," "underlying" and the like for describing the location of various layers, refer to the relative position of a layer with respect to a horizontally-disposed, upwardly-facing substrate. It is not intended that the substrate, layers or articles encompassing the substrate and layers, should have any particular orientation in space during or after manufacture.

The term "separated by" to describe the position of a layer with respect to another layer and the substrate, or two other layers, means that the described layer is between, but not necessarily contiguous with, the other layer(s) and/or substrate.

The term "(co)polymer" or "(co)polymeric" includes homopolymers and copolymers, as well as homopolymers or copolymers that may be formed in a miscible blend, *e.g.,* by coextrusion or by reaction, including, *e.g.,* transesterification. The term "copolymer" includes random, block, graft, and star copolymers.

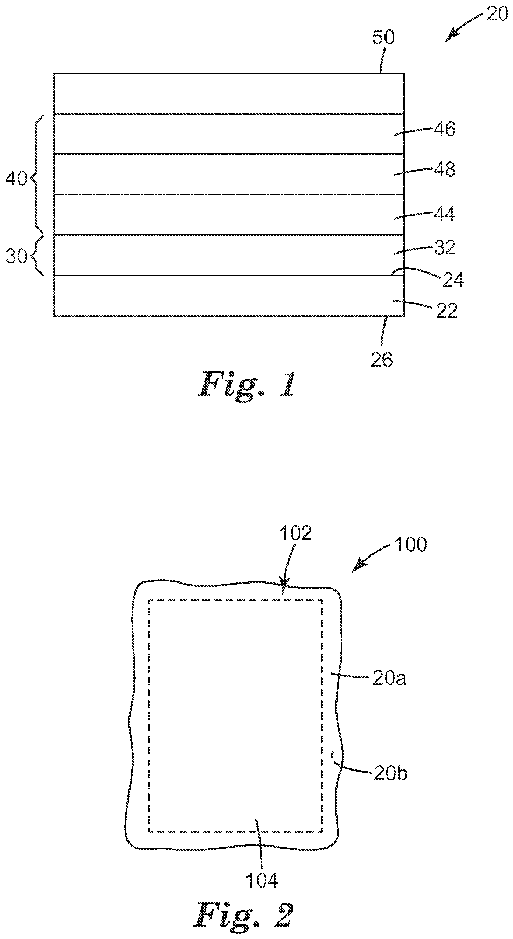

The present disclosure provides barrier films, VIP envelopes formed from these barrier films, and VIPs comprising these envelopes. Referring now to FIG. 1, an exemplary barrier film 20 according to the present disclosure is illustrated. Barrier film 20 includes substrate 22 which has first 24 and second 26 major surfaces. In direct contact with the first major surface 24 of the substrate 22 is a first layer 30, which is in turn in contact with second layer 40. The layer to be described below as first layer 30 and the layer to be described below as second layer 40 may actually be applied in either order to substrate 22 and still achieve suitable barrier properties, and either order is considered within the scope of the present disclosure.

First layer 30 in some embodiments, such as the depicted embodiment, is a low thermal conductivity polymer organic layer 32 comprised of cross-linked (meth)acrylate monomers. Additionally, good flexibility, toughness, and adhesion to the selected substrate are considered desirable. The low thermal conductivity organic layer 32 may be prepared by conventional coating methods such as roll coating (e.g., gravure roll coating) or spray coating (e.g., electrostatic spray coating) the monomer, and then crosslinking by using, e.g., ultraviolet light radiation. The low thermal conductivity organic layer 32 may also be prepared by flash evaporation of the monomer, vapor deposition, followed by crosslinking, as described in the following U.S. Pat. No. 4,842,893 (Yializis et al.); U.S. Pat. No. 4,954,371 (Yializis); U.S. Pat. No. 5,032,461 (Shaw et al.); U.S. Pat. No. 5,440,446 (Shaw et al.); U.S. Pat. No. 5,725,909 (Shaw et al.); U.S. Pat. No. 6,231,939 (Shaw et al.); U.S. Pat. No. 6,045,864 (Lyons et al.); U.S. Pat. No. 6,224,948 (Affinito), and U.S. Pat. Application 2008/0292810 (Anderson et al.).

Second layer 40 in some embodiments, such as the depicted embodiment, is a low thermal conductivity inorganic stack (collectively 44, 46, and 48 in the depicted embodiment). This low thermal conductivity inorganic stack includes at least one low thermal conductivity non-metallic inorganic material 44 and at least one low thermal conductivity metallic inorganic material 46. Low thermal conductivity non-metallic inorganic material 44 has a thermal conductivity of no more than 0.5, or even 0.015 W/(m•°K).

Low thermal conductivity metallic inorganic material 46 has a thermal conductivity of no more than 1, or even 0.2 W/(m•°K). A low level of emissivity, with values less than 0.6, or even 0.1 is considered desirable as another property useful in a suitable low thermal conductivity metallic inorganic material 46.

In some depicted embodiments, an optional second low thermal conductivity metallic inorganic material 48 is present to provide desirable physical properties. In particular, for example, a layer of silicon aluminum provides the properties of flexibility and faster deposition compared to the silicon aluminum oxide layer just discussed. Such layers are conveniently applied by sputtering, and a thickness between about 10 and 50 nm is considered convenient, with approximately 20 nm in thickness being considered particularly suitable.

Some embodiments, such as the depicted embodiment further include an optional polymeric layer 50 applied to the second layer 40 on the side away from the substrate 22. Such a layer may be employed to physically protect the non-metallic inorganic material 44. Some embodiments may include additional layers in order to achieve desirable properties. For example, if additional barrier properties are deemed desirable, an additional layer of non-metallic inorganic material may optionally be applied, including, e.g. above the protective second polymer layer.

Referring now to **FIG. 2****,** a front view of a completed vacuum insulation panel 100 employing the envelope of **FIG. 1** is illustrated. Two sheets of barrier film 20a and 20b have been attached face to face, conveniently by heat welding, to form vacuum insulation panel envelope 102. Within the envelope 102, is a core 104, seen in outline in this view. The core 104 is vacuum sealed within envelope 102.

### Substrates

The substrate 22 is conveniently a polymeric layer. While diverse polymers may be used, when the barrier film is used for vacuum insulated panels, puncture resistance and thermal stability are properties to be particularly prized. Examples of useful polymeric puncture resistant films include polymers such as polyethylene (PE), polyethylene terephthalate (PET), polypropylene (PP), polyethylene napthalate (PEN), polyether sulfone (PES), polycarbonate, polyestercarbonate, polyetherimide (PEI), polyarylate (PAR), polymers with trade name ARTON (available from the Japanese Synthetic Rubber Co., Tokyo, Japan), polymers with trade name AVATREL (available from the B.F. Goodrich Co., Brecksville, Ohio), polyethylene-2,6-naphthalate, polyvinylidene difluoride, polyphenylene oxide, polyphenylene sulfide, polyvinyl chloride (PVC), and ethylene vinyl alcohol (EVOH). Also useful are the thermoset polymers such as polyimide, polyimide benzoxazole, polybenzoaxozole and cellulose derivatives. Polyethylene terephthalate (PET) with a thickness of approximately 0.002 inch (0.05 mm) is considered a convenient choice, as is biaxially oriented polypropylene (BOPP) film. Biaxially oriented polypropylene (BOPP) is commercially available from several suppliers including: ExxonMobil Chemical Company of Houston, Tex.; Continental Polymers of Swindon, UK; Kaisers International Corporation of Taipei City, Taiwan and PT Indopoly Swakarsa Industry (ISI) of Jakarta, Indonesia. Other examples of suitable film material are taught in WO 02/11978, titled "Cloth-like Polymeric Films," (Jackson et al.). In some embodiments, the substrate may be a lamination of two or more polymeric layers.

### Low thermal conductivity organic layer

When the low thermal conductivity organic layer 32 is to be formed by flash evaporation of the monomer, vapor deposition, followed by crosslinking, volatilizable acrylate and methacrylate (referred to herein as "(meth)acrylate") monomers are useful, with volatilizable acrylate monomers being preferred. A suitable (meth)acrylate monomer has sufficient vapor pressure to be evaporated in an evaporator and condensed into a liquid or solid coating in a vapor coater.

Examples of suitable monomers include, but are not limited to, hexadiol diacrylate; ethoxyethyl acrylate; cyanoethyl (mono)acrylate; isobornyl (meth)acrylate; octadecyl acrylate; isodecyl acrylate; lauryl acrylate; beta-carboxyethyl acrylate; tetrahydrofurfuryl acrylate; dinitrile acrylate; pentafluorophenyl acrylate; nitrophenyl acrylate; 2-phenoxyethyl (meth)acrylate; 2,2,2-trifluoromethyl (meth)acrylate; diethylene glycol diacrylate; triethylene glycol di(meth)acrylate; tripropylene glycol diacrylate; tetraethylene glycol diacrylate; neo-pentyl glycol diacrylate; propoxylated neopentyl glycol diacrylate; polyethylene glycol diacrylate; tetraethylene glycol diacrylate; bisphenol A epoxy diacrylate; 1,6-hexanediol dimethacrylate; trimethylol propane triacrylate; ethoxylated trimethylol propane triacrylate; propylated trimethylol propane triacrylate; tris(2 - hydroxyethyl)-isocyanurate triacrylate; pentaerythritol triacrylate; phenylthioethyl acrylate; naphthloxyethyl acrylate; epoxy acrylate under the product number RDX80094 (available from RadCure Corp., Fairfield, N.J.); and mixtures thereof. A variety of other curable materials can be included in the polymer layer, such as, e.g., vinyl ethers, vinyl mapthalene, acrylonitrile, and mixtures thereof.

In particular, tricyclodecane dimethanol diacrylate is considered suitable. It is conveniently applied by, e.g., condensed organic coating followed by UV initiated free radical vinyl polymerization. A thickness between about 250 and 1500 nm is considered convenient, with approximately 750 nm in thickness being considered particularly suitable.

### Low emissivity metallic inorganic materials

The low emissivity metallic materials useful, for example, in at least one low thermal conductivity metallic inorganic material 46 and/or 48, include aluminum, but is preferably silver, gold, copper, tin, chrome, nickel, platinum, tungsten, zinc, magnesium, molybdenum, rhodium, and/or alloys or combinations of the same. The metal is deposited at sufficient thickness to provide very low emissivity, preferably less than 0.6, or even less than 0.1. In particular, a copper-tin alloy, Cu₈₀Sn₂₀ by weight, commercially available as a sputtering target from DHF of Los Angeles, CA, is considered convenient, having a an emissivity "ε" of 0.07 and a thermal conductivity "k" of 0.26 W/(m•°K). Silicon aluminum is also useful.

In some embodiments, it may be convenient to partially oxidize the low emissivity metallic material. In some embodiments, the low emissivity metallic inorganic material may be accompanied by an additional interlayer of low thermal conductivity metallic material, which may or may not also have low emissivity.

### Low thermal conductivity non-metallic inorganic material

The low thermal conductivity non-metallic inorganic material 44 may conveniently be formed of metal oxides, metal nitrides, metal oxy-nitrides, and metal alloys of oxides, nitrides and oxy-nitrides. In one aspect the low thermal conductivity non-metallic inorganic material 44 comprises a metal oxide. Preferred metal oxides include aluminum oxide, silicon oxide, silicon aluminum oxide, aluminum-silicon-nitride, and aluminum-silicon-oxy-nitride, CuO, TiO₂, ITO, Si₃N₄, TiN, ZnO, aluminum zinc oxide, ZrO₂, and yttria-stabilized zirconia. The use of Ca₂SiO₄ is contemplated due to its flame retardant properties. The low thermal conductivity non-metallic inorganic material 44 may be prepared by a variety of methods, such as those described in U.S. Pat. No. 5,725,909 (Shaw et al.) and U.S. Pat. No. 5,440,446 (Shaw et al.). Low thermal conductivity non-metallic inorganic material can typically be prepared by reactive evaporation, reactive sputtering, chemical vapor deposition, plasma enhanced chemical vapor deposition, and atomic layer deposition. Preferred methods include vacuum preparations such as reactive sputtering and plasma enhanced chemical vapor deposition.

The low thermal conductivity non-metallic inorganic material 44 is conveniently applied as a thin layer. Silicon aluminum oxide is considered particularly convenient because it provides good barrier properties, as well as good interfacial adhesion to the optional second polymeric layer 50. Such layers are conveniently applied by sputtering, and a thickness between about 5 and 100 nm is considered convenient, with approximately 20 nm in thickness being considered particularly suitable.

### Core

Referring again to FIG. 2, in some embodiments, vacuum insulated panel 100 includes a core 104, conveniently in the form of a rigid foam having small open cells, for example on the order of four microns in size. One source for the microporous foam core is Dow Chemical Company of Midland, MI. In some embodiments, parallel spaced evacuation passages or grooves are cut or formed in the face of the core. Information on how the core may be vacuum sealed within the envelope is disclosed in US Patent 6,106,449 (Wynne). Other useful materials include fumed silica, glass fiber, and aerogels.

### Heat seal layer

An optional heat seal layer may also be present. Polyethylene, or a blend of linear low-density polyethylene and low-density polyethylene, are considered suitable. A heat seal layer may be applied to the barrier film by extrusion, coating, or lamination. A coextruded composite layer comprising a high-density polyethylene is also considered suitable.

### Fire retardant layer

It may be convenient that the envelope have fire retardant properties. For example, the substrate may itself comprise a flame retardant material, or a separate flame retardant layer may be positioned in direct contact with an opposing major surface of the substrate opposite the first layer. Information on fire retardant materials suitable for use in layered products is found in U.S. Patent Application 2012/0164442 (Ong et al.), which is herein incorporated by reference.

### Design considerations to minimize disruption of the insulation properties during assembly

The barrier film 20 as described above includes some layers, especially low thermal conductivity inorganic stack 40, and most especially low thermal conductivity non-metallic inorganic material 44, which can be somewhat brittle. The barrier film 20 will lose some of its good (low) thermal conductivity properties if the vacuum seal it provides is broken. During the manufacturing of the finished VIP, the barrier film is submitted to high strain and stress, especially during the vacuum suction step. Considering the film as a beam undergoing bending, it has a neutral plane where compressive stress across the thickness of the beam becomes zero and changes over to tensile stress. Therefore it is desirable to assess the mechanical properties of the materials chosen for the barrier film 20, including any optional heat seal and flame retardant layers, and sizing the thickness of each so that the low thermal conductivity inorganic stack 40 is at or near the neutral plane of the film with respect to motions that bend the film away from its flat state. A barrier film can be said to meet this criterion if the centerline with respect to the thickness of the layer of low thermal conductivity non-metallic inorganic material 44 is positioned within ± 10% of the total thickness of all the layers (including optional layers) comprising the barrier film 20 from the calculated neutral plane of the barrier film 20. In some convenient embodiments, the centerline with respect to the thickness of the layer of low thermal conductivity non-metallic inorganic material 44 is positioned within ± 5% of the total thickness of all the layers (including optional layers) comprising the barrier film 20 from the calculated neutral plane of the barrier film 20.

Exemplary embodiments of the present disclosure have been described above and are further illustrated below by way of the following Examples, which are not to be construed in any way as imposing limitations upon the scope of the present disclosure. On the contrary, it is to be clearly understood that resort may be had to various other modifications thereof which, after reading the description herein, may suggest themselves to those skilled in the art without departing from the scope of the appended claims.

### EXAMPLES

The following examples are intended to illustrate exemplary embodiments within the scope of this disclosure. Notwithstanding that the numerical ranges and parameters setting forth the broad scope of the disclosure are approximations, the numerical values set forth in the specific examples are reported as precisely as possible. Any numerical value, however, inherently contains certain errors necessarily resulting from the standard deviation found in their respective testing measurements. At the very least, each numerical parameter should at least be construed in light of the number of reported significant digits and by applying ordinary rounding techniques.

### Test Methods

### Water vapor transmission rate

Some of the following Examples were tested for barrier properties on a vapor transmission testing commercially available as PERMATRAN W700 from Mocon of Minneapolis, MN. The testing regime was 50°C and 100% RH.

### Flex resistance test

Some of the examples were tested for flex resistance using the gelbo-flex from Vinatoru Enterprises, Inc of Graham, NC. The sample size (200 by 280 mm) is attached to the flex tester mandrels. The flexing action consists of a twisting motion combined with a horizontal motion (compression), thus repeatedly twisting and crushing the film. The test set up gives a twisting motion of 440° in the first 90 mm of the stroke and is followed by a straight horizontal motion of 65 mm. The speed is 45 cycles per minute.

### EXAMPLES

The following Examples of barrier films were made on a vacuum coater similar to the coater described in U.S. Pat. Nos. 5,440,446 (Shaw et al.) and 7,018,713 (Padiyath, et al.). This coater was threaded up with a substrate in the form of an indefinite length roll of 0.05 mm thick, 14 inch (35.6 cm) wide PET film commercially available from DuPont-Teijin Films of Chester, VA. This substrate was then advanced at a constant line speed of 16 fpm (4.9 m/min). The substrate was prepared for coating by subjecting it to a nitrogen plasma treatment to improve the adhesion of the low thermal conductivity organic layer.

### Example 1

A low thermal conductivity organic layer was formed on the substrate by applying tricyclodecane dimethanol diacrylate, commercially available as SARTOMER SR833S from Sartomer USA of Exton, PA, by ultrasonic atomization and flash evaporation to make a coating width of 12.5 inches (31.8 cm). This monomeric coating was subsequently cured immediately downstream with an electron beam curing gun operating at 7.0 kV and 4.0 mA. The flow of liquid into the evaporator was 1.33 ml/min, the gas flow rate was 60 sccm and the evaporator temperature was set at 260°C. The process drum temperature was -10°C.

On top of this low thermal conductivity organic layer, the low thermal conductivity inorganic stack was applied, starting with the low thermal conductivity metallic inorganic material. More specifically, a conventional AC sputtering process operated at 4 kW of power was employed to deposit a 15 nm thick layer of copper onto the now polymerized low thermal conductivity organic layer (the book value of the thermal conductivity of copper is 3.9 W/(m•°K) and the emissivity ε is 0.03). Then a low thermal conductivity non-metallic inorganic material was laid down by an AC reactive sputter deposition process employing a 40 kHz AC power supply. The cathode had a Si(90%)/Al(10%) target obtained from Soleras Advanced Coatings US, of Biddeford, (ME). The voltage for the cathode during sputtering was controlled by a feed-back control loop that monitored the voltage and controlled the oxygen flow such that the voltage would remain high and not crash the target voltage. The system was operated at 16 kW of power to deposit a 20 nm thick layer of silicon aluminum oxide onto the copper layer.

A further in-line process was used to deposit a second polymeric layer on top of the silicon aluminum oxide layer. This polymeric layer was produced from monomer solution by atomization and evaporation. However, the material applied to form this top layer was a mixture of 3 wt% (N-(n-butyl)-3-aminopropyltrimethoxysilane commercially available as DYNASILAN 1189 from Evonik of Essen, DE; 1 wt% 1-hydroxy-cyclohexyl-phenyl-ketone commercially available as IRGACURE 184 from BASF of Ludwigshafen, DE; with the remainder SARTOMER SR833S. The flow rate of this mixture into the atomizer was 1.33 ml/min, the gas flow rate was 60 sccm, and the evaporator temperature was 260°C. Once condensed onto the silicon aluminum oxide layer, the coated mixture was cured to a finished polymer with an UV light.

The resulted article was found to possess low-e and low-k functionalities. It was tested for water vapor transmission according to the test method discussed above. The water vapor transmission rate in this experiment was found to be below the detection limit for the apparatus.

### Example 2

A barrier film was prepared according to the procedure of Example 1, except that the substrate was a 0.05 mm thick biaxially oriented polypropylene. It was tested for water vapor transmission according to the test method discussed above, and the water vap or transmission rate was found to be below the detection limit for the apparatus.

### Example 3

A barrier film was prepared on the apparatus of Example 1. This coater was threaded up with a substrate in the form of an indefinite length roll of 0.0014 inch (0.036 mm) thick PET film commercially available from 3M Company of St. Paul, MN. This substrate was then advanced at a constant line speed of 16 fpm (4.9 m/min). The substrate was prepared for coating by subjecting it to a plasma treatment to improve the adhesion of the low thermal conductivity organic layer.

A low thermal conductivity organic layer was formed on the substrate by applying tricyclodecane dimethanol diacrylate, commercially available as SARTOMER SR833S from Sartomer USA of Exton, PA, by ultrasonic atomization and flash evaporation to make a coating width of 12.5 inches (31.8 cm). This monomeric coating was subsequently cured immediately downstream with an electron beam curing gun operating at 7.0 kV and 4.0 mA. The flow of liquid into the evaporator was 1.33 ml/min, the gas flow rate was 60 sccm and the evaporator temperature was set at 260°C. The process drum temperature was -10°C.

On top of this low thermal conductivity organic layer, the low thermal conductivity inorganic stack was applied, starting with the low thermal conductivity metallic inorganic material. More specifically, a conventional AC sputtering process operated at 4 kW of power was employed to deposit a 15 nm thick layer of copper onto the now polymerized low thermal conductivity organic layer. Then a low thermal conductivity non-metallic inorganic material was laid down by an AC reactive sputter deposition cathode employing a 40 kHz AC power supply. The cathode had a Si(90%)/Al(10%) target obtained from Soleras Advanced Coatings US. The voltage for the cathode during sputtering was controlled by a feed-back control loop that monitored the voltage and controlled the oxygen flow such that the voltage would remain high and not crash the target voltage. The system was operated at 16 kW of power to deposit a 20 nm thick layer of silicon aluminum oxide onto the copper layer.

The resulted article was found to possess low-e and low-k functionalities. It was tested for water vapor transmission according to the test method discussed above. The water vapor transmission rate in this experiment was found to be below the detection limit for the apparatus.

### Example 4

A barrier film was prepared generally according to the procedure of Example 3, except for the following particulars. The flow rate of monomer into the evaporator was 1.33 ml/min, and the silicon aluminum layer was 5 kW.

### Example 5

A barrier film was prepared generally according to the procedure of Example 3, except for the following particulars. The flow rate of monomer into the evaporator was 1.33 ml/min, and the power used to deposit the oxide was 4kW. Further, above the low thermal conductivity inorganic stack, a further in-line process was used to deposit a second polymeric layer on top of the silicon aluminum oxide layer. This polymeric layer was produced from monomer solution by atomization and evaporation. However, the material applied to form this top layer was a mixture of 3 wt% (N-(n-butyl)-3-aminopropyltrimethoxysilane commercially available as DYNASILAN 1189 from Evonik of Essen, DE; 1 wt% 1-hydroxy-cyclohexyl-phenyl-ketone commercially available as IRGACURE 184 from BASF of Ludwigshafen, DE; with the remainder SARTOMER SR833S. The flow rate of this mixture into the atomizer was 1.33 ml/min, the gas flow rate was 60 sccm, and the evaporator temperature was 260°C. Once condensed onto the silicon aluminum oxide layer, the coated mixture was cured to a finished polymer with an UV light.

### Example 6

A barrier film was prepared generally according to the procedure of Example 3, except for the following particulars. Above the second polymeric layer, a second layer of silicon-aluminum oxide was laid down by an AC reactive sputter deposition cathode. The cathode had a Si(90%)/Al(10%) target obtained from Soleras Advanced Coatings US. The system was operated at 16 kW of power to deposit an approximately 25 nm thick layer of silicon aluminum oxide onto the second polymer layer.

### Examples 7-10

Four barrier films were prepared generally according to the procedures of Examples 3-6 respectively, except that the substrate for these Examples was a low density polyethylene/PET lamination, 0.00092 inch (0.023 mm) thick. The polyethylene portion of this lamination is commercially available from Berry Plastics of Evansville, IN. The PET side of the lamination faced the low thermal conductivity organic layer.

### Example 11

A barrier film was prepared on the apparatus of Example 1. The substrate was PET film, 0.00092 inch (0.023 mm) thick, commercially available as LUMIRROR F7S from Toray of Tokyo, Japan. This substrate was then advanced at a constant line speed of 16 fpm (4.9 m/min). The substrate was prepared for coating by subjecting it to a plasma treatment to improve the adhesion of the low thermal conductivity organic layer.

A low thermal conductivity organic layer was formed on the substrate by applying tricyclodecane dimethanol diacrylate, commercially available as SARTOMER SR833S from Sartomer USA of Exton, PA, by ultrasonic atomization and flash evaporation to make a coating width of 12.5 inches (31.8 cm). This monomeric coating was subsequently cured immediately downstream with an electron beam curing gun operating at 7.0 kV and 4.0 mA. The flow of liquid into the evaporator was 1.33 ml/min, the gas flow rate was 60 sccm and the evaporator temperature was set at 260°C. The process drum temperature was -10°C.

On top of this low thermal conductivity organic layer, the low thermal conductivity inorganic stack was applied, starting with the low thermal conductivity metallic inorganic material. More specifically, a conventional AC sputtering process operated at 4 kW of power was employed to deposit a 20 nm thick layer of silicon aluminum alloy onto the now polymerized low thermal conductivity organic layer. The 90%Si/10%Al sputter target employed was obtained from obtained from DHF of Los Angeles, CA. Then a low thermal conductivity non-metallic inorganic material was laid down by an AC reactive sputter deposition cathode employing a 40 kHz AC power supply. The cathode had a Si(90%)/Al(10%) target obtained from Soleras Advanced Coatings US, of Biddeford, (ME). The voltage for the cathode during sputtering was controlled by a feed -back control loop that monitored the voltage and controlled the oxygen flow such that the voltage would remain high and not crash the target voltage. The system was operated at 16 kW of power to deposit a 25 nm thick layer of silicon aluminum oxide onto the copper layer.

A further in-line process was used to deposit a second polymeric layer on top of the silicon aluminum oxide layer. This polymeric layer was produced from monomer solution by atomization and evaporation. However, the material applied to form this top layer was a mixture of 3 wt% (N-(n-butyl)-3-aminopropyltrimethoxysilane commercially available as DYNASILAN 1189 from Evonik of Essen, DE; 1 wt% 1-hydroxy-cyclohexyl-phenyl-ketone commercially available as IRGACURE 184 from BASF of Ludwigshafen, DE; with the remainder SARTOMER SR833S. The flow rate of this mixture into the atomizer was 1.33 ml/min, the gas flow rate was 60 sccm, and the evaporator temperature was 260°C. Once condensed onto the silicon aluminum oxide layer, the coated mixture was cured to a finished polymer with an UV light.

The resulted article was found to possess low-k functionalities. It was tested for water vapor transmission according to the test method discussed above. The water vapor transmission rate in this experiment was found to be below the detection limit for the apparatus.

### Example 12

A barrier film was prepared generally according to the procedures of Example 11, except that the line speed was doubled to 32 feet/min (9.8 m/min), and the monomer flow to produce the low thermal conductivity organic layer and the second polymer layer was also doubled. This caused the thickness of low thermal conductivity organic layer and the second polymer layer to remain at roughly 750 nm, while the thickness of the silicon aluminum layer was diminished to 10 nm and the thickness of the silicon aluminum oxide layer was diminished to 12 nm.

### Example 13

A barrier film was prepared generally according to the procedure of Example 11, except for the following particulars. Above the second polymeric layer, a second layer of silicon-aluminum oxide was laid down by an AC reactive sputter deposition cathode. The cathode had a Si(90%)/Al(10%) target obtained from Soleras Advanced Coatings US. The system was operated at 16 kW of power to deposit a 25 nm thick layer of silicon aluminum oxide onto the second polymeric layer.

### Example 14

A barrier film was prepared generally according to the procedure of Example 3, except for the following particulars. Instead of using copper for the low thermal conductivity metallic inorganic material, a conventional AC sputtering process operated at 4 kW of power was employed to deposit a 20 nm thick layer of titanium onto the low thermal conductivity organic layer.

### Example 15

A barrier film was prepared generally according to the procedure of Example 3, except for the following particulars. Instead of using copper for the low thermal conductivity metallic inorganic material, a conventional AC sputtering process operated at 4 kW of power was employed to deposit a 20 nm thick layer of copper-tin alloy, Cu₈₀Sn₂₀ by weight, onto the low thermal conductivity organic layer.

### Example 16

A barrier film was prepared generally according to the procedure of Example 15, except for the following particulars. Between the steps of depositing the layer of copper-tin alloy and the step of depositing the layer of silicon-aluminum oxide, an interlayer of titanium, 20 nm thick was deposited by a conventional AC sputtering process operated at 4 kW of power.

### Example 17

A barrier film was prepared on a vacuum coater similar to the coater described in U.S. Pat. Nos. 5,440,446 (Shaw et al.) and 7,018,713 (Padiyath, et al.). This coater was threaded up with a substrate in the form of an indefinite length roll of 0.024 mm thick, 14 inch (35.6 cm) wide PET film commercially available from DuPont-Teijin Films of Chester, VA. This substrate was then advanced at a constant line speed of 16 fpm (4.9 m/min). The substrate was prepared for coating by subjecting it to a nitrogen plasma treatment to improve the adhesion of the low thermal conductivity organic layer.

A low thermal conductivity organic layer was formed on the substrate by applying tricyclodecane dimethanol diacrylate, commercially available as SARTOMER SR833S from Sartomer USA of Exton, PA, by ultrasonic atomization and flash evaporation to make a coating width of 12.5 inches (31.8 cm). This monomeric coating was subsequently cured immediately downstream with an electron beam curing gun operating at 7.0 kV and 4.0 mA. The flow of liquid into the evaporator was 1.33 ml/min, the gas flow rate was 60 sccm and the evaporator temperature was set at 260°C. The process drum temperature was -10°C.

On top of this low thermal conductivity organic layer, the low thermal conductivity inorganic stack was applied, starting with the low thermal conductivity metallic inorganic material. More specifically, a conventional AC sputtering process operated at 4 kW of power was employed to deposit a 10 nm thick layer of silicon aluminum alloy onto the now polymerized low thermal conductivity organic layer. The 90%Si/10%Al sputter target employed was obtained from obtained from DHF of Los Angeles, CA. Then a low thermal conductivity non-metallic inorganic material was laid down by an AC reactive sputter deposition process employing a 40 kHz AC power supply. The cathode had a Si(90%)/Al(10%) target obtained from Soleras Advanced Coatings US, of Biddeford, ME. The voltage for the cathode during sputtering was controlled by a feed-back control loop that monitored the voltage and controlled the oxygen flow such that the voltage would remain high and not crash the target voltage. The system was operated at 16 kW of power to deposit a 20 nm thick layer of silicon aluminum oxide onto the silicon aluminum alloy layer.

A further in-line process was used to deposit a second polymeric layer on top of the silicon aluminum oxide layer. This polymeric layer was produced from monomer solution by atomization and evaporation. However, the material applied to form this top layer was a mixture of 3 wt% (N-(n-butyl)-3-aminopropyltrimethoxysilane commercially available as DYNASILAN 1189 from Evonik of Essen, DE; 1 wt% 1 -hydroxy-cyclohexyl-phenyl-ketone commercially available as IRGACURE 184 from BASF of Ludwigshafen, DE; with the remainder SARTOMER SR833S. The flow rate of this mixture into the atomizer was 1.33 ml/min, the gas flow rate was 60 sccm, and the evaporator temperature was 260°C. Once condensed onto the silicon aluminum oxide layer, the coated mixture was cured to a finished polymer with an UV light.

The second polymeric layer was then coated with a two-component laminating adhesive system that combines an isocyanate-terminated polyester urethane with a coreactant, commercially available as ADCOAT 577 from Dow Chemical of Midland, MI. A coating weight of 0.5 grains per 4" x 6" rectangle (2.1 g/m²) was employed. A heat seal layer was then laminated to the laminating adhesive, specifically a film of High Density Polyethylene (HDPE) having a thickness of 1.8 mil (0.045 mm) and a tensile modulus of 135,000 psi (931 MPa), commercially available from Printpack, Inc. of Atlanta, GA. The use of this material as the heat seal layer was calculated to place the low thermal conductivity non-metallic inorganic material at or near the neutral plane of the total film.

Two films of this construction were then used for the manufacture of a VIP, which the heat-seal layer of each heat-sealed together around a core. The resulting VIP was found to possess enhanced mechanical and barrier properties. A single film of this construction was tested for water vapor transmission according to the test method discussed above. The water vapor transmission rate in this experiment was found to be below the detection limit for the apparatus.

Further a single film of this construction was subjected to a flex resistance test, and the WVTR was tested before and after. The test was performed according to ASTM F392 (2011) "Standard Practice for Conditioning Flexible Barrier Materials for Flex Durability" After being submitted to 20 cycles of twisting/crushing motion according to the protocol, the WVTR of the envelope increased only from < 0.005 g/m²/day to 0.65 g/m²/day.

### Example 18

A barrier film and a VIP were prepared according to the procedure of Example 17, except that the heat seal layer was a Low Density Polyethylene (LDPE) having a thickness of 3.2 mil (0.081 mm) and a tensile modulus of 30,000 psi (207 MPa), commercially available from Printpack, Inc. The use of this material as the heat seal layer was calculated to place the low thermal conductivity non-metallic inorganic material at or near the neutral plane of the total film.

This barrier film was also used for the heat-sealing process in the manufacture process of VIPs. Further a single film of this construction was subjected to a flex resistance test, and the WVTR was tested before and after. After being submitted to 20 cycles of twisting/crushing motion according to ASTM F392, the film showed a WVTR of 0.7 g/m²/day.

### Example 19

A barrier film and a VIP were prepared according to the procedure of Example 17, except that the heat seal layer was a Linear Low Density Polyethylene (LLDPE) having a thickness of 3.2 mil (0.081 mm) and a tensile modulus of 27,000 psi (186 MPa), commercially available from Printpack, Inc. The use of this material as the heat seal layer was calculated to place the low thermal conductivity non-metallic inorganic material at or near the neutral plane of the total film.

While the specification has described in detail certain exemplary embodiments, it will be appreciated that those skilled in the art, upon attaining an understanding of the foregoing, may readily conceive of alterations thereto and variations thereof. Accordingly, it should be understood that this disclosure is not to be unduly limited to the illustrative embodiments set forth hereinabove. Various exemplary embodiments have been described. These and other embodiments are within the scope of the following claims.

## Claims

1. An article comprising a vacuum insulation panel envelope comprising:
(a) a polymeric film substrate having two opposing major surfaces;
(b) a first layer in direct contact with one of the opposing major surfaces of the substrate, wherein the first layer is a low thermal conductivity organic polymer layer (32) comprised of cross-linked (meth)acrylate monomers or a low thermal conductivity inorganic stack, wherein the low thermal conductivity inorganic stack (44, 46, 48) includes at least a layer (44) having a thickness between 5 and 100 nm and a thermal conductivity of no more than 0.5 W/(m*K) and being comprised of at least one low thermal conductivity non-metallic inorganic material, and a layer (46) having a thermal conductivity of no more than 1 W/(m*K) and being comprised of at least one low thermal conductivity metallic inorganic material;
(c) a second layer in direct contact with the first layer, wherein the second layer is a low thermal conductivity organic polymer layer (32) comprised of cross-linked (meth)acrylate monomers or a low thermal conductivity inorganic stack, wherein the low thermal conductivity inorganic stack (44, 46, 48) includes at least a layer (44) having a thickness between 5 and 100 nm and a thermal conductivity of no more than 0.5 W/(m*K) and being comprised of at least one low thermal conductivity non-metallic inorganic material , and a layer (46) having a thermal conductivity of no more than 1 W/(m*K) and being comprised of at least one low thermal conductivity metallic inorganic material, and
further wherein when the first layer is a low thermal conductivity organic polymer layer (32), the second layer is a low thermal conductivity inorganic stack (44, 46, 48), an outer stack layer thereof being in direct contact with the first layer, and when the second layer is a low thermal conductivity organic polymer layer (32), the first layer is a low thermal conductivity inorganic stack (44, 46, 48), an outer stack layer thereof being in direct contact with the said major surface of the substrate and the other outer stack layer thereof being in direct contact with the second layer.

2. The article of claim 1 wherein the layer (46) of the low thermal conductivity inorganic stack (44, 46, 48) comprised of the at least one low thermal conductivity metallic inorganic material comprises a low emissivity metallic inorganic material and has an emissivity of less than 0.6, or wherein the low thermal conductivity inorganic stack (44, 46, 48) further comprises a layer (48) having a thickness between 10 and 50 nm and being comprised of a second low thermal conductivity metallic inorganic material and positioned between the layer (46) comprised of the at least one low thermal conductivity metallic inorganic material and the layer (44) comprised of the at least one low thermal conductivity non-metallic inorganic material.

3. The article of any of the preceding claims further comprising at least one of an additional low conductivity organic layer, or a heat seal layer.

4. The article of any one of the preceding claims wherein the substrate comprises a flame retardant material, optionally wherein the flame retardant material is in direct contact with an opposing major surface of the substrate opposite the first layer.

5. The article of any one of claims 1 to 4 wherein the low thermal conductivity non-metallic inorganic materials are selected from at least one of aluminum oxide, silicon oxide, aluminum-silicon-oxide, aluminum-silicon-nitride, and aluminum-silicon-oxy-nitride, CuO, TiO₂, ITO, Si₃N₄, TiN, ZnO, aluminum zinc oxide, ZrO₂, yttria-stabilized zirconia and Ca₂SiO₄.

6. The article of any one of claims 2 to 4 wherein the low thermal conductivity metallic inorganic materials are selected from at least one of Ti, Sr, V, Mn, Ni, Cr, Sn, and Co.

7. The article of any one of claims 2 to 4 wherein the low emissivity metallic inorganic materials are selected from at least one of aluminum, silver, gold, copper, tin, chrome, nickel, platinum, tungsten, zinc, magnesium, molybdenum, rhodium, silicon and/or alloys or combinations of the same.

8. The article of any one of the preceding claims wherein the vacuum insulation panel envelope has an oxygen transmission rate of less than 0.1 cc/m²/day and a moisture vapor transmission rate of less than 0.1 g/m²/day.

9. A barrier film comprising:
(a) a polymeric film substrate having two opposing major surfaces;
(b) a first layer in direct contact with one of the opposing major surfaces of the substrate, wherein the first layer is a low thermal conductivity organic polymer layer (32) comprised of cross-linked (meth)acrylate monomers or a low thermal conductivity inorganic stack, wherein the low thermal conductivity inorganic stack (44, 46, 48) includes at least a layer (44) having a thickness between 5 and 100 nm and a thermal conductivity of no more than 0.5 W/(m*K) and being comprised of at least one low thermal conductivity non-metallic inorganic material, and a layer (46) having a thermal conductivity of no more than 1 W/(m*K) and being comprised of a low thermal conductivity metallic inorganic material
(c) a second layer in direct contact with the first layer, wherein the second layer is a low thermal conductivity organic polymer layer (32) comprised of cross-linked (meth)acrylate monomers or a low thermal conductivity inorganic stack, wherein the low thermal conductivity inorganic stack (44, 46, 48) includes at least a layer (44) having a thickness between 5 and 100 nm and a thermal conductivity of no more than 0.5 W/(m*K) and being comprised of at least one low thermal conductivity non-metallic inorganic material, and a layer (46) having a thermal conductivity of no more than 1 W/(m*K) and being comprised of at least one low thermal conductivity metallic inorganic material, and
further wherein when the first layer is a low thermal conductivity organic polymer layer (32), the second layer is a low thermal conductivity inorganic stack (44, 46, 48), an outer stack layer thereof being in direct contact with the first layer, and when the second layer is a low thermal conductivity organic polymer layer (32), the first layer is a low thermal conductivity inorganic stack (44, 46, 48), an outer stack layer thereof being in direct contact with the said major surface of the substrate and the other outer stack layer thereof being in direct contact with the second layer.

10. The barrier film of claim 9 wherein the layer (46) of the low thermal conductivity inorganic stack (44, 46, 48) comprised of the at least one low thermal conductivity metallic inorganic material comprises a low emissivity metallic inorganic material and has an emissivity of less than 0.6, or wherein the low thermal conductivity inorganic stack (44, 46, 48) further comprises a layer (48) having a thickness between 10 and 50 nm and being comprised of a second low thermal conductivity metallic inorganic material and positioned between the layer (46) comprised of the at least one low thermal conductivity metallic inorganic material and the layer (44) comprised of the at least one low thermal conductivity non-metallic inorganic material.

11. The barrier film of any one of claims 9 to 10 further comprising at least one of a heat seal layer, or a flame retardant material.

12. The barrier film of any one of claims 9 to 11 further comprising a flame retardant layer in direct contact with an opposing major surface of the substrate opposite the first layer.

13. The barrier film of any one of claims 9 to 12 wherein the low thermal conductivity non-metallic inorganic materials are selected from at least one of aluminum oxide, silicon oxide, aluminum-silicon-oxide, aluminum-silicon-nitride, and aluminum-silicon-oxy-nitride CuO, TiO₂, ITO, Si₃N₄, TiN, ZnO, aluminum zinc oxide, ZrO₂, yttria-stabilized zirconia and Ca₂SiO₄.

14. The barrier film of any one of claims 9 to 13 wherein the low thermal conductivity metallic inorganic materials are selected from at least one of Ti, Sr, V, Mn, Ni, Cr, Sn, and Co.

15. The barrier film of any one of claims 10 to 14 wherein the low emissivity metallic inorganic materials are selected from at least one of aluminum, silver, gold, copper and/or alloys or combinations of the same aluminum, silver, gold, copper, tin, chrome, nickel, platinum, tungsten, zinc, magnesium, molybdenum, rhodium, silicon and/or alloys or combinations of the same.

## Patentansprüche

1. Ein Gegenstand, umfassend eine Hülle für ein vakuumisoliertes Paneel, umfassend:
(a) ein Polymerfoliensubstrat mit zwei gegenüberliegenden Hauptoberflächen;
(b) eine erste Schicht in direktem Kontakt mit einer der gegenüberliegenden Hauptoberflächen des Substrats, wobei die erste Schicht eine organische Polymerschicht mit niedriger Wärmeleitfähigkeit (32) bestehend aus quervernetzten (Meth)acrylatmonomeren oder ein anorganischer Stapel mit niedriger Wärmeleitfähigkeit ist, wobei der anorganische Stapel mit niedriger Wärmeleitfähigkeit (44, 46, 48) mindestens eine Schicht (44), die eine Dicke zwischen 5 und 100 nm und eine Wärmeleitfähigkeit von nicht mehr als 0,5 W/(m*K) aufweist und aus mindestens einem nichtmetallischen anorganischen Material mit niedriger Wärmeleitfähigkeit besteht, und eine Schicht (46), die eine Wärmeleitfähigkeit von nicht mehr als 1 W/(m*K) aufweist und aus mindestens einem metallischen anorganischen Material mit niedriger Wärmeleitfähigkeit besteht, enthält;
(c) eine zweite Schicht in direktem Kontakt mit der ersten Schicht, wobei die zweite Schicht eine organische Polymerschicht mit niedriger Wärmeleitfähigkeit (32) bestehend aus quervernetzten (Meth)acrylatmonomeren oder ein anorganischer Stapel mit niedriger Wärmeleitfähigkeit ist, wobei der anorganische Stapel mit niedriger Wärmeleitfähigkeit (44, 46, 48) mindestens eine Schicht (44), die eine Dicke zwischen 5 und 100 nm und eine Wärmeleitfähigkeit von nicht mehr als 0,5 W/(m*K) aufweist und aus mindestens einem nichtmetallischen anorganischen Material mit niedriger Wärmeleitfähigkeit besteht, und eine Schicht (46), die eine Wärmeleitfähigkeit von nicht mehr als 1 W/(m*K) aufweist und aus mindestens einem metallischen anorganischen Material mit niedriger Wärmeleitfähigkeit besteht, enthält, und
wobei ferner, wenn die erste Schicht eine organische Polymerschicht mit niedriger Wärmeleitfähigkeit (32) ist, die zweite Schicht ein anorganischer Stapel mit niedriger Wärmeleitfähigkeit (44, 46, 48) ist, wobei eine äußere Stapelschicht davon in direktem Kontakt mit der ersten Schicht ist, und wenn die zweite Schicht eine organische Polymerschicht mit niedriger Wärmeleitfähigkeit (32) ist, die erste Schicht ein anorganischer Stapel mit niedriger Wärmeleitfähigkeit (44, 46, 48) ist, wobei eine äußere Stapelschicht davon in direktem Kontakt mit der Hauptoberfläche des Substrats ist und die andere äußere Stapelschicht davon in direktem Kontakt mit der zweiten Schicht ist.

2. Der Gegenstand nach Anspruch 1, wobei die Schicht (46) des anorganischen Stapels mit niedriger Wärmeleitfähigkeit (44, 46, 48), die aus dem mindestens einen metallischen anorganischen Material mit niedriger Wärmeleitfähigkeit besteht, ein metallisches anorganisches Material mit niedrigem Emissionsvermögen umfasst und ein Emissionsvermögen von weniger als 0,6 aufweist oder wobei der anorganische Stapel mit niedriger Wärmeleitfähigkeit (44, 46, 48) ferner eine Schicht (48) umfasst, die eine Dicke zwischen 10 und 50 nm aufweist und aus einem zweiten metallischen anorganischen Material mit niedriger Wärmeleitfähigkeit besteht und zwischen der Schicht (46), die aus dem mindestens einen metallischen anorganischen Material mit niedriger Wärmeleitfähigkeit besteht, und der Schicht (44), die aus dem mindestens einen nichtmetallischen anorganischen Material mit niedriger Wärmeleitfähigkeit besteht, positioniert ist.

3. Der Gegenstand nach einem der vorstehenden Ansprüche, ferner umfassend mindestens eine von einer zusätzlichen organischen Schicht mit niedriger Leitfähigkeit oder einer Heißsiegelschicht.

4. Der Gegenstand nach einem der vorstehenden Ansprüche, wobei das Substrat ein flammhemmendes Material umfasst, wobei das flammhemmende Material optional in direktem Kontakt mit einer gegenüberliegenden Hauptoberfläche des Substrats gegenüber der ersten Schicht ist.

5. Der Gegenstand nach einem der Ansprüche 1 bis 4, wobei die nichtmetallischen anorganischen Materialien mit niedriger Wärmeleitfähigkeit ausgewählt sind aus mindestens einem von Aluminiumoxid, Siliciumoxid, Aluminium-Siliciumoxid, Aluminium-Siliciumnitrid und Aluminium-Siliciumoxynitrid, CuO, TiO₂, ITO, Si₃N₄ TiN, ZnO, Aluminium-Zinkoxid, ZrO₂, Yttriumoxid-stabilisiertem Zirconiumdioxid und Ca₂SiO₄.

6. Der Gegenstand nach einem der Ansprüche 2 bis 4, wobei die metallischen anorganischen Materialien mit niedriger Wärmeleitfähigkeit ausgewählt sind aus mindestens einem von Ti, Sr, V, Mn, Ni, Cr, Sn und Co.

7. Der Gegenstand nach einem der Ansprüche 2 bis 4, wobei die metallischen anorganischen Materialien mit niedrigem Emissionsvermögen ausgewählt sind aus mindestens einem von Aluminium, Silber, Gold, Kupfer, Zinn, Chrom, Nickel, Platin, Wolfram, Zink, Magnesium, Molybdän, Rhodium, Silicium und/oder Legierungen oder Kombinationen davon.

8. Der Gegenstand nach einem der vorstehenden Ansprüche, wobei die Hülle für ein vakuumisoliertes Paneel eine Sauerstoffdurchlässigkeitsrate von weniger als 0,1 cc/m²/Tag und eine Wasserdampfdurchlässigkeitsrate von weniger als 0,1 g/m²/Tag aufweist.

9. Eine Barrierefolie, umfassend:
(a) ein Polymerfoliensubstrat mit zwei gegenüberliegenden Hauptoberflächen;
(b) eine erste Schicht in direktem Kontakt mit einer der gegenüberliegenden Hauptoberflächen des Substrats, wobei die erste Schicht eine organische Polymerschicht mit niedriger Wärmeleitfähigkeit (32) bestehend aus quervernetzten (Meth)acrylatmonomeren oder ein anorganischer Stapel mit niedriger Wärmeleitfähigkeit ist, wobei der anorganische Stapel mit niedriger Wärmeleitfähigkeit (44, 46, 48) mindestens eine Schicht (44), die eine Dicke zwischen 5 und 100 nm und eine Wärmeleitfähigkeit von nicht mehr als 0,5 W/(m*K) aufweist und aus mindestens einem nichtmetallischen anorganischen Material mit niedriger Wärmeleitfähigkeit besteht, und eine Schicht (46), die eine Wärmeleitfähigkeit von nicht mehr als 1 W/(m*K) aufweist und aus einem metallischen anorganischen Material mit niedriger Wärmeleitfähigkeit besteht, enthält;
(c) eine zweite Schicht in direktem Kontakt mit der ersten Schicht, wobei die zweite Schicht eine organische Polymerschicht mit niedriger Wärmeleitfähigkeit (32) bestehend aus quervernetzten (Meth)acrylatmonomeren oder ein anorganischer Stapel mit niedriger Wärmeleitfähigkeit ist, wobei der anorganische Stapel mit niedriger Wärmeleitfähigkeit (44, 46, 48) mindestens eine Schicht (44), die eine Dicke zwischen 5 und 100 nm und eine Wärmeleitfähigkeit von nicht mehr als 0,5 W/(m*K) aufweist und aus mindestens einem nichtmetallischen anorganischen Material mit niedriger Wärmeleitfähigkeit besteht, und eine Schicht (46), die eine Wärmeleitfähigkeit von nicht mehr als 1 W/(m*K) aufweist und aus mindestens einem metallischen anorganischen Material mit niedriger Wärmeleitfähigkeit besteht, enthält, und
wobei ferner, wenn die erste Schicht eine organische Polymerschicht mit niedriger Wärmeleitfähigkeit (32) ist, die zweite Schicht ein anorganischer Stapel mit niedriger Wärmeleitfähigkeit (44, 46, 48) ist, wobei eine äußere Stapelschicht davon in direktem Kontakt mit der ersten Schicht ist, und wenn die zweite Schicht eine organische Polymerschicht mit niedriger Wärmeleitfähigkeit (32) ist, die erste Schicht ein anorganischer Stapel mit niedriger Wärmeleitfähigkeit (44, 46, 48) ist, wobei eine äußere Stapelschicht davon in direktem Kontakt mit der Hauptoberfläche des Substrats ist und die andere äußere Stapelschicht davon in direktem Kontakt mit der zweiten Schicht ist.

10. Die Barrierefolie nach Anspruch 9, wobei die Schicht (46) des anorganischen Stapels mit niedriger Wärmeleitfähigkeit (44, 46, 48), die aus dem mindestens einen metallischen anorganischen Material mit niedriger Wärmeleitfähigkeit besteht, ein metallisches anorganisches Material mit niedrigem Emissionsvermögen umfasst und ein Emissionsvermögen von weniger als 0,6 aufweist oder wobei der anorganische Stapel mit niedriger Wärmeleitfähigkeit (44, 46, 48) ferner eine Schicht (48) umfasst, die eine Dicke zwischen 10 und 50 nm aufweist und aus einem zweiten metallischen anorganischen Material mit niedriger Wärmeleitfähigkeit besteht und zwischen der Schicht (46), die aus dem mindestens einen metallischen anorganischen Material mit niedriger Wärmeleitfähigkeit besteht, und der Schicht (44), die aus dem mindestens einen nichtmetallischen anorganischen Material mit niedriger Wärmeleitfähigkeit besteht, positioniert ist.

11. Die Barrierefolie nach einem der Ansprüche 9 bis 10, ferner umfassend mindestens eines von einer Heißsiegelschicht oder einem flammhemmenden Material.

12. Die Barrierefolie nach einem der Ansprüche 9 bis 11, ferner umfassend eine flammhemmende Schicht in direktem Kontakt mit einer gegenüberliegenden Hauptoberfläche des Substrats gegenüber der ersten Schicht.

13. Die Barrierefolie nach einem der Ansprüche 9 bis 12, wobei die nichtmetallischen anorganischen Materialien mit niedriger Wärmeleitfähigkeit ausgewählt sind aus mindestens einem von Aluminiumoxid, Siliciumoxid, Aluminium-Siliciumoxid, Aluminium-Siliciumnitrid und Aluminium-Siliciumoxynitrid, CuO, TiO₂, ITO, Si₃N₄ TiN, ZnO, Aluminium-Zinkoxid, ZrO₂, Yttriumoxid-stabilisiertem Zirconiumdioxid und Ca₂SiO₄.

14. Die Barrierefolie nach einem der Ansprüche 9 bis 13, wobei die metallischen anorganischen Materialien mit niedriger Wärmeleitfähigkeit ausgewählt sind aus mindestens einem von Ti, Sr, V, Mn, Ni, Cr, Sn und Co.

15. Die Barrierefolie nach einem der Ansprüche 10 bis 14, wobei die metallischen anorganischen Materialien mit niedrigem Emissionsvermögen ausgewählt sind aus mindestens einem von Aluminium, Silber, Gold, Kupfer und/oder Legierungen oder Kombinationen derselben Aluminium, Silber, Gold, Kupfer, Zinn, Chrom, Nickel, Platin, Wolfram, Zink, Magnesium, Molybdän, Rhodium, Silicium und/oder Legierungen oder Kombinationen derselben.

## Revendications

1. Article comprenant une enveloppe de panneau d'isolation à vide comprenant :
(a) un substrat de film polymère ayant deux surfaces principales opposées ;
(b) une première couche en contact direct avec l'une des surfaces principales opposées du substrat, dans lequel la première couche est une couche polymère organique à faible conductivité thermique (32) constituée de monomères (méth)acrylate réticulés ou un empilement inorganique à faible conductivité thermique, dans lequel l'empilement inorganique à faible conductivité thermique (44, 46, 48) inclut au moins une couche (44) ayant une épaisseur entre 5 et 100 nm et une conductivité thermique n'excédant pas 0,5 W/(m*K) et étant constituée d'au moins un matériau inorganique non métallique à faible conductivité thermique, et une couche (46) ayant une conductivité thermique n'excédant pas 1 W/(m*K) et étant constituée d'au moins un matériau inorganique métallique à faible conductivité thermique ;
(c) une deuxième couche en contact direct avec la première couche, dans lequel la deuxième couche est une couche polymère organique à faible conductivité thermique (32) constituée de monomères (méth)acrylate réticulés ou un empilement inorganique à faible conductivité thermique, dans lequel l'empilement inorganique à faible conductivité thermique (44, 46, 48) inclut au moins une couche (44) ayant une épaisseur entre 5 et 100 nm et une conductivité thermique n'excédant pas 0,5 W/(m*K) et étant constituée d'au moins un matériau inorganique non métallique à faible conductivité thermique, et une couche (46) ayant une conductivité thermique n'excédant pas 1 W/(m*K) et étant constituée d'au moins un matériau inorganique métallique à faible conductivité thermique, et
dans lequel en outre lorsque la première couche est une couche polymère organique à faible conductivité thermique (32), la deuxième couche est un empilement inorganique à faible conductivité thermique (44, 46, 48), une couche d'empilement externe de celle-ci étant en contact direct avec la première couche, et lorsque la deuxième couche est une couche polymère organique à faible conductivité thermique (32), la première couche est un empilement inorganique à faible conductivité thermique (44, 46, 48), une couche d'empilement externe de celle-ci étant en contact direct avec ladite surface principale du substrat et l'autre couche d'empilement externe de celle-ci étant en contact direct avec la deuxième couche.

2. Article selon la revendication 1, dans lequel la couche (46) de l'empilement inorganique à faible conductivité thermique (44, 46, 48) constituée de l'au moins un matériau inorganique métallique à faible conductivité thermique comprend un matériau inorganique métallique à faible émissivité et a une émissivité inférieure à 0,6, ou dans lequel l'empilement inorganique à faible conductivité thermique (44, 46, 48) comprend en outre une couche (48) ayant une épaisseur entre 10 et 50 nm et étant constituée d'un deuxième matériau inorganique métallique à faible conductivité thermique et positionnée entre la couche (46) constituée de l'au moins un matériau inorganique métallique à faible conductivité thermique et la couche (44) constituée de l'au moins un matériau inorganique non métallique à faible conductivité thermique.

3. Article selon l'une quelconque des revendications précédentes comprenant en outre au moins l'une parmi une couche organique à faible conductivité supplémentaire, ou une couche de thermoscellage.

4. Article selon l'une quelconque des revendications précédentes dans lequel le substrat comprend un matériau ignifugeant, facultativement dans lequel le matériau ignifugeant est en contact direct avec une surface principale opposée du substrat opposée à la première couche.

5. Article selon l'une quelconque des revendications 1 à 4 dans lequel les matériaux inorganiques non métalliques à faible conductivité thermique sont choisis parmi au moins l'un parmi oxyde d'aluminium, oxyde de silicium, oxyde d'aluminium-silicium, nitrure d'aluminium-silicium, et oxy-nitrure d'aluminium-silicium, CuO, TiO₂, ITO, Si₃N₄ TiN, ZnO, oxyde d'aluminium et de zinc, ZrO₂, zircone stabilisée à l'yttrium et Ca₂SiO₄.

6. Article selon l'une quelconque des revendications 2 à 4 dans lequel les matériaux inorganiques métalliques à faible conductivité thermique sont choisis parmi au moins l'un parmi Ti, Sr, V, Mn, Ni, Cr, Sn et Co.

7. Article selon l'une quelconque des revendications 2 à 4 dans lequel les matériaux inorganiques métalliques à faible émissivité sont choisis parmi au moins l'un parmi aluminium, argent, or, cuivre, étain, chrome, nickel, platine, tungstène, zinc, magnésium, molybdène, rhodium, silicium et/ou alliages ou combinaisons de ceux-ci.

8. Article selon l'une quelconque des revendications précédentes dans lequel l'enveloppe de panneau d'isolation à vide a un taux de transmission d'oxygène inférieur à 0,1 cm³/m²/jour et un taux de transmission de vapeur humide inférieur à 0,1 g/m²/jour.

9. Film barrière comprenant :
(a) un substrat de film polymère ayant deux surfaces principales opposées ;
(b) une première couche en contact direct avec l'une des surfaces principales opposées du substrat, dans lequel la première couche est une couche polymère organique à faible conductivité thermique (32) constituée de monomères (méth)acrylate réticulés ou un empilement inorganique à faible conductivité thermique, dans lequel l'empilement inorganique à faible conductivité thermique (44, 46, 48) inclut au moins une couche (44) ayant une épaisseur entre 5 et 100 nm et une conductivité thermique n'excédant pas 0,5 W/(m*K) et étant constituée d'au moins un matériau inorganique non métallique à faible conductivité thermique, et une couche (46) ayant une conductivité thermique n'excédant pas 1 W/(m*K) et étant constituée d'un matériau inorganique métallique à faible conductivité thermique
(c) une deuxième couche en contact direct avec la première couche, dans lequel la deuxième couche est une couche polymère organique à faible conductivité thermique (32) constituée de monomères (méth)acrylate réticulés ou un empilement inorganique à faible conductivité thermique, dans lequel l'empilement inorganique à faible conductivité thermique (44, 46, 48) inclut au moins une couche (44) ayant une épaisseur entre 5 et 100 nm et une conductivité thermique n'excédant pas 0,5 W/(m*K) et étant constituée d'au moins un matériau inorganique non métallique à faible conductivité thermique, et une couche (46) ayant une conductivité thermique n'excédant pas 1 W/(m*K) et étant constituée d'au moins un matériau inorganique métallique à faible conductivité thermique, et
dans lequel en outre lorsque la première couche est une couche polymère organique à faible conductivité thermique (32), la deuxième couche est un empilement inorganique à faible conductivité thermique (44, 46, 48), une couche d'empilement externe de celle-ci étant en contact direct avec la première couche, et lorsque la deuxième couche est une couche polymère organique à faible conductivité thermique (32), la première couche est un empilement inorganique à faible conductivité thermique (44, 46, 48), une couche d'empilement externe de celle-ci étant en contact direct avec ladite surface principale du substrat et l'autre couche d'empilement externe de celle-ci étant en contact direct avec la deuxième couche.

10. Film barrière selon la revendication 9, dans lequel la couche (46) de l'empilement inorganique à faible conductivité thermique (44, 46, 48) constituée de l'au moins un matériau inorganique métallique à faible conductivité thermique comprend un matériau inorganique métallique à faible émissivité et a une émissivité inférieure à 0,6, ou dans lequel l'empilement inorganique à faible conductivité thermique (44, 46, 48) comprend en outre une couche (48) ayant une épaisseur entre 10 et 50 nm et étant constituée d'un deuxième matériau inorganique métallique à faible conductivité thermique et positionnée entre la couche (46) constituée de l'au moins un matériau inorganique métallique à faible conductivité thermique et la couche (44) constituée de l'au moins un matériau inorganique non métallique à faible conductivité thermique.

11. Film barrière selon l'une quelconque des revendications 9 à 10 comprenant en outre au moins l'un parmi une couche de thermoscellage, ou un matériau ignifugeant.

12. Film barrière selon l'une quelconque des revendications 9 à 11 comprenant en outre une couche ignifugeante en contact direct avec une surface principale opposée du substrat opposée à la première couche.

13. Film barrière selon l'une quelconque des revendications 9 à 12 dans lequel les matériaux inorganiques métalliques à faible conductivité thermique sont choisis parmi au moins l'un parmi oxyde d'aluminium, oxyde de silicium, oxyde d'aluminium-silicium, nitrure d'aluminium-silicium, et oxy-nitrure d'aluminium-silicium, CuO, TiO₂, ITO, Si₃N₄, TiN, ZnO, oxyde d'aluminium et de zinc, ZrO₂, zircone stabilisée à l'yttrium et Ca₂SiO₄.

14. Film barrière selon l'une quelconque des revendications 9 à 13 dans lequel les matériaux inorganiques métalliques à faible conductivité thermique sont choisis parmi au moins l'un parmi Ti, Sr, V, Mn, Ni, Cr, Sn et Co.

15. Film barrière selon l'une quelconque des revendications 10 à 14 dans lequel les matériaux inorganiques métalliques à faible émissivité sont choisis parmi au moins l'un parmi aluminium, argent, or, cuivre et/ou alliages ou combinaisons de ceux-ci, aluminium, argent, or, cuivre, étain, chrome, nickel, platine, tungstène, zinc, magnésium, molybdène, rhodium, silicium et/ou alliages ou combinaisons de ceux-ci.
